# EUROPEAN PATENT SPECIFICATION

(11) **EP 3 857 592 B1**
(45) Date of publication and mention of the grant of the patent: **13.12.2023**
(21) Application number: 19865166.3
(22) Date of filing: 27.09.2019
(51) Int. Cl.: H01L 21/68, H01L 21/67, B25J 11/00, B25J 15/06, B23K 1/00, B23K 1/008, B23K 1/20, B23K 3/06, B23K 3/08, H01L 21/683

(54) **MULTIPLE MODULE CHIP MANUFACTURING ARRANGEMENT**
ANORDNUNG ZUR HERSTELLUNG VON CHIPS MIT MEHREREN MODULEN
AGENCEMENT DE FABRICATION DE PUCES À MODULES MULTIPLES

(30) Priority: 28.09.2018 US 201862766076 P
(43) Date of publication of application: 04.08.2021
(73) Proprietor: Boston Process Technologies, Inc., Peabody, Massachusetts 01960 (US)
(72) Inventor: ZHANG, Jian, Brookline, Massachusetts 02446 (US)
(74) Representative: Dummett Copp LLP
(86) International application number: PCT/US2019/053421
(87) International publication number: WO 2020/069294

(56) References cited:
- WO-A1-2019/032486
- CN-A- 103 606 527
- CN-A- 104 347 452
- JP-A- H1 126 923
- JP-A- 2003 303 926
- JP-A- 2004 330 261
- JP-A- 2009 071 332
- JP-A- 2015 082 630
- KR-B1- 101 027 491
- KR-B1- 101 027 491
- KR-B1- 101 141 921
- US-A- 4 848 641
- US-A- 4 848 641
- US-A1- 2003 110 626
- US-A1- 2003 110 626
- US-A1- 2008 296 355
- US-A1- 2009 026 247
- US-A1- 2009 026 247
- US-A1- 2009 057 372
- US-A1- 2009 057 372
- US-A1- 2010 127 049
- US-A1- 2012 031 954
- US-A1- 2015 034 702
- US-A1- 2015 097 025
- US-A1- 2015 122 876
- US-A1- 2015 122 876
- US-A1- 2015 230 346
- US-A1- 2019 043 745
- US-B1- 6 182 356
- US-B1- 6 412 680
- US-B1- 6 413 850
- US-B1- 6 413 850
- US-B1- 6 604 673
- US-B2- 8 708 215

## Description

### Background of the Invention

The present invention relates to assemblies and subassembly modules for the manufacture of wafer chips or substrates with solder balls or plated solder balls (which may also be called bumps attached thereto), and more particularly to devices for processing wafers with a flux less or flux free binder in a connectable arrangement of treatment modules intermatingly adaptable to changing conditions of such wafer chip manufacture. For discussion here, plated solder balls, solder balls, bumps and the like will all be designated "solder balls" to avoid confusion. KR 101 027 491 B1 (describing all the features of the preamble of claims 1 and 11) discloses a solder ball printer in which flux is printed onto electrode pads on a substrate and solder balls are located onto the flux. US 2015/0122876 A1 discloses a system and method for coating flux materials onto a substrate, reflowing the flux on the substrate, and removing flux and cleaning the substrate. US 2003/0110626 A1 discloses a method of locating solder balls onto pre-fluxed pads on a substrate using a stencil plate. JP 2015 082630 A discloses a soldering method using powder solder and a continuous reflow furnace. US 6,413,850 B1 discloses a method of forming solder bumps using a suction head and a stencil to apply solder balls to pads with adhesive on a substrate.

### Brief Summary of the Invention

The present invention relates to an arrangement of individual modules which taken together comprise a system for the manufacture of wafer chips with solder balls arranged thereon. The modules within the system are each designed to promote the efficient manufacture of that component of the chip assembly needed for the completion.

For marketing purposes, the assembly may be called herein by a trade name, the "Symphony" chip assembly arrangement or tool.

The Symphony chip assembly tool comprises a front end module (EFEM), a binder application module, a solder ball mount module (SBM), an inspection and repair module, and a reflow module. A robotic arm is arranged in the front end module to move wafers between the respective modules and a pre-aligner for course wafer arrangement. A further embodiment of the Symphony tool assembly comprises a side by side arrangement of multiple reflow modules. A front end module (EFEM) is may also be arranged adjacent the multiple reflow modules to permit their servicing in parallel so as to increase the throughput of the reflow process. A yet a further embodiment of the Symphony assembly, comprises a dual solder ball mount module configuration, arranged to increase the throughput of the ball mount step. Such further dual solder ball mount configuration comprises a front end module (EFEM), with two solder ball mount (SBM) modules for processing in parallel thereadjacent, a binder application module, and an inspection module. A still yet a further embodiment of the Symphony tool assembly, comprises a single reflow module configuration with its attendant front end module (EFEM) servicing that single reflow module.

The invention thus comprises a unitary wafer assembly arrangement for the application of solder balls onto a wafer substrate for subsequent use in the electronics industry and a corresponding process as defined in claims 1 and 11.

The invention also comprises a process for the manufacture of a chip assembly in a unitary wafer assembly system, for use in the electronics industry as defined in claim 16.

Further embodiments of the present invention are defined in the dependent claims.

### Brief description of the drawings

The objects and advantages of the present invention will become more apparent when viewed in conjunction with the following drawings, in which:
figure 1 is a recitation of the steps that the apparatus of the present invention processes to produce a proper chip with electronics industry;
figure 2 is a plan schematic view of an assembly tool arrangement, also showing the robotic arm arrangement for transferring wafers from station to station within the assembly tool assembly;
figure 3 is a perspective view of the binder module for the application of binder fluid to a wafer undergoing construction;
figure 4 is a side elevational view in section, of the binder application chamber shown in figure 6A;
figure 5 is a perspective view in section of a wafer support plate or chuck for the lifting of a wafer thereon into the binder application enclosure;
figure 6 is a perspective view of a solder ball mount module showing a robotic arm for feeding wafers to the solder ball mount module, and its associated optic inspection arrangement;
figure 7 is a perspective view of the solder ball mount module shown in figure 9 with the inspection optics and the camera arrangement showing a gantry arrangement;
figure 7A is a side elevational view of a brush head showing a final or the distribution of solder balls onto a primary distribution plate and several secondary distribution plates thereunder with a sweeper arrangement attached to the bottom of the brush head, with a stencil shown therebeneath spaced above a wafer supported on a chuck;
figure 8 is a perspective view of the underside of the ball brush arrangement;
figures 9A, 9B and 9C are perspective and side elevational views respectively, of an inspection module of the present assembly whereby the wafer is inspected to make sure that all solder balls are correctly positioned on a wafer before being reflowed, wherein a line scan camera located in the upper portion of the inspection module looks downwardly upon the wafer on the support chuck so as to capture an image of the entire wafer for computer analysis;
figure 9D is a perspective exploded view of a repair station which complements the inspection module; and
figure 10 is a perspective view of an open reflow module which comprises a chamber with three stations, a load lock station a reflow station, and a warpage management station wherein a wafer is moved station to station within the chamber by a rotating carrier disc.

### Detailed description of the invention

The disclosure in its general aspects comprises an apparatus and the process of that apparatus for the treatment of a wafer for use in the electronics industry, is as follows: a wafer to be treated is removed from the raw wafer stacking by a robotic amr; the wafer is delivered to a pre-alignment station where it is centered on a carrier; wafer is brought to a station in an adjacent binder module; a fluid binder is applied to the wafer; the wafer is then removed by the robotic arm to a solder ball mount station module; wafer is aligned by cameras in the first support opening so as to orient in the line the wafer with a stencil hole pattern; the wafer is brought to a second support opening the solder ball mount module with the stencil resides; a chuck is moved upwardly to support the wafer in a very close position beneath the stencil, (the distance between the wafer and the stencil is less than the diameter of a solder ball), solder balls are dropped from a reservoir into a cup and perforated plate distribution arrangement in the solder ball mount module, the solder balls fall through the perforated plate arrangement and into holes of a stencil for alignment onto a wafer there beneath, the ball loaded wafer being brushed and treated with compressed dry air effects placement of the solder balls and removal of excess solder balls from the wafer, the wafer being carried to a reflow station for final heat treatment and cooling of the solder ball loaded wafer. Such apparatus and process treatment is recited more specifically in figure 1.

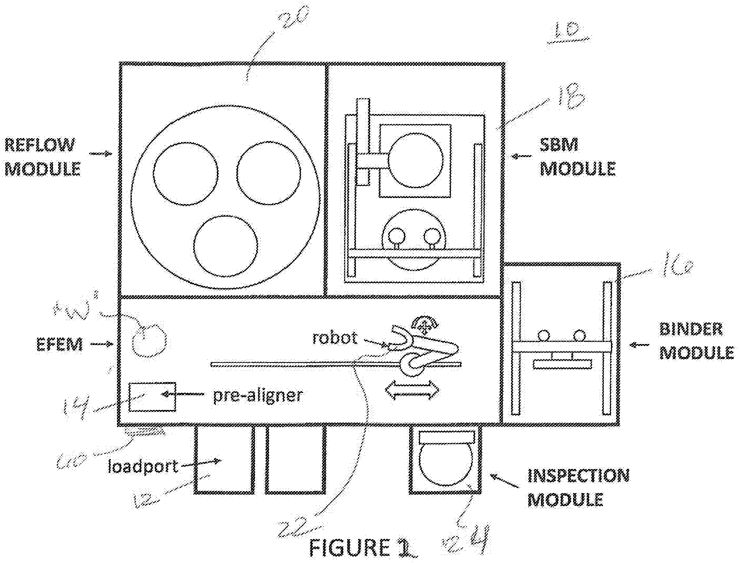

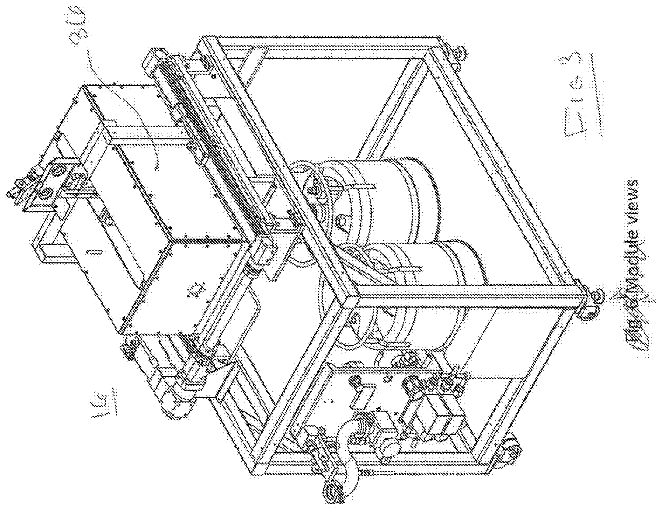

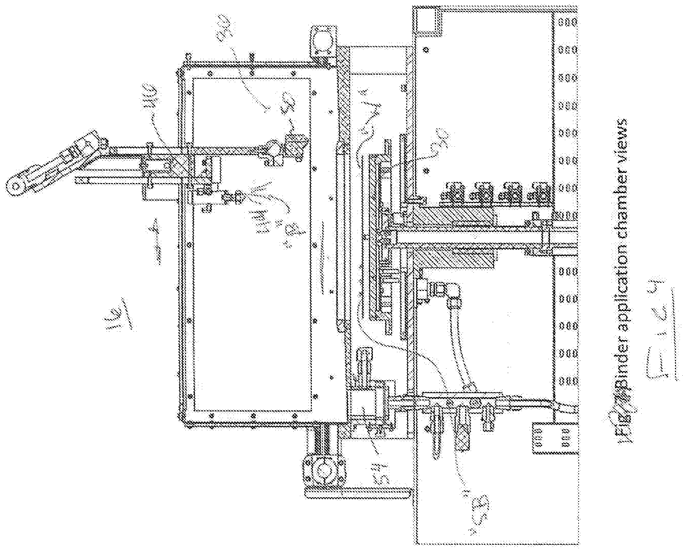

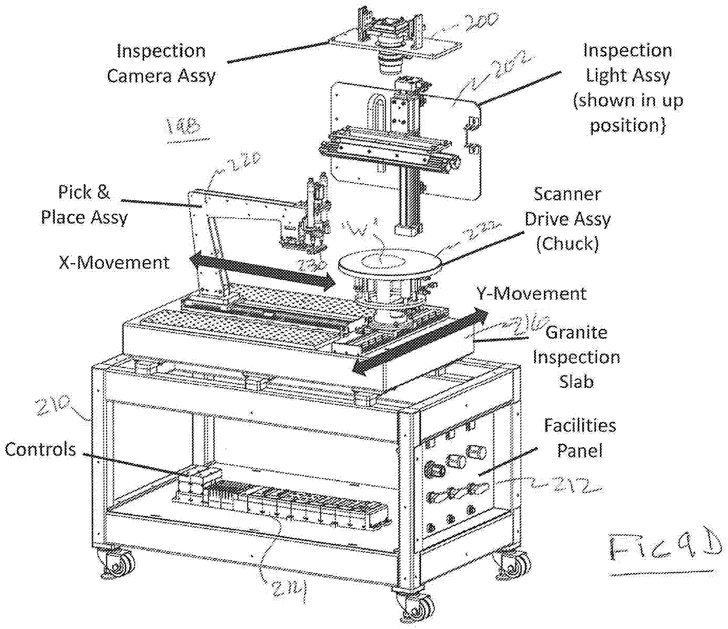

Referring now to the drawings in detail and particularly to figure 2, there is shown a schematic representation of a configuration of the unitary chip assembly tool 10. The chip assembly tool 10 comprises a load port 12, a pre-aligner module 14, a binder module 16, a solder ball mount module 18 and a reflow module 20 each of which are serviced by the sequential loading and unloading by a central robotic arm arrangement 22. The binder module is shown in figure 3 in a perspective view, and in figure 4 in a side elevational view. An inspection module 24 is also shown in figure 2, which inspection module may include an inspection plus arrangement or repair of improperly loaded wafers, disclosed more specifically in figure 9D.

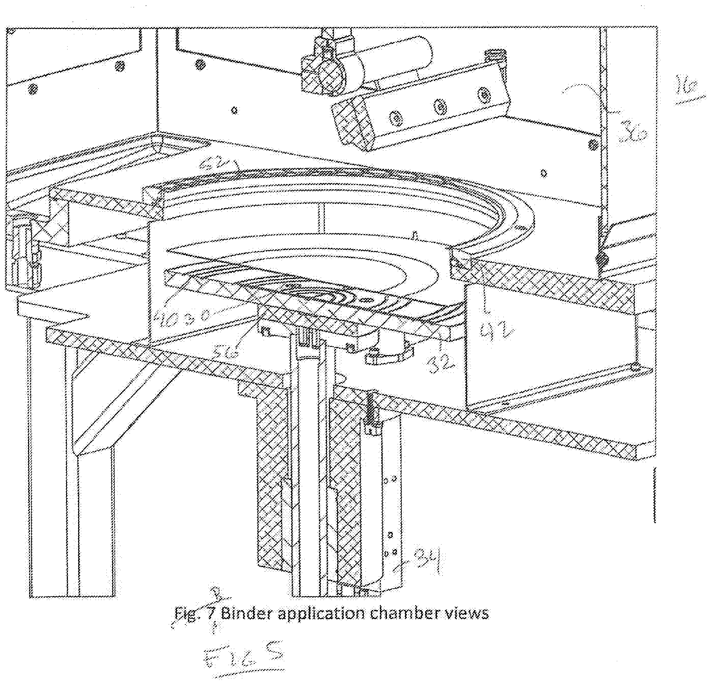

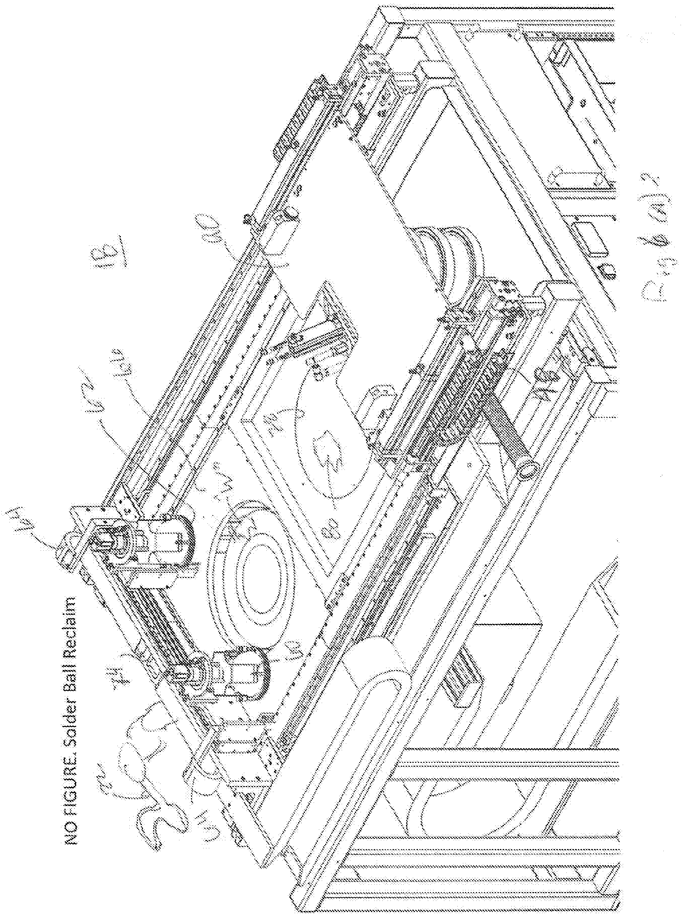

The operation of the chip assembly tool 10 as shown in figure 2, is begun at the load the port wherein a wafer "W" is taken from a front opening unified pod (FOUP) and transferred to the binder module 16. A robotic arm 22 effector places the wafer "W" on support pins 30 as represented in figure 4. These support pins 30 have vacuum cups at their tips to hold the wafer "W" after has been placed on by the robotic arm 22 onto a vacuum support plate 32 as represented in figure 5, which plate 32 is then raised, driven by a pneumatic actuator 34, to lift the wafer "W" into the binder application enclosure 36 as shown in figures 4 and 5. The support pins 30 are buried just below the surface of the support plate 32 and rise up with the plate 32 as it is raised. As the support plate 32 rises, it engages the wafer "W" and holds it tight against the support plate 32 by using a vacuum through the support plate 32. The support plate 32 has three independently controlled vacuum zones, each comprised of and defined by a series of vacuum channels 40, best seen in figure 5. Besides holding the wafers W, the multizone design enables the plate 32 to flatten and hold a warped wafer. As the support plate reaches the top of the stroke it engages with a clamping ring 42 shown in figure 5, which ring 42 acts as a hard stop. The inner edge of the clamp ring 42 presses on outer edge of the wafer W and forms a liquid tight seal. Liquid binder "B" is dispensed, as representative in figure 4, by one or more nozzles 44 as shown in figure 4 which nozzles 44 scan across the wafer "W" one or more times. The nozzles 44 evenly distribute a fluid binder "B", by spraying it in a fan pattern approximately normal to the scan direction. The nozzles 44 are carried on a gantry 46 as shown in figure 4 which gantry motion is driven by computer-controlled linear actuator with a belt drive 48 as shown in figure 6. After depositing the binder B, an air knife 50, as shown in figure 4 scans over the wafer, jetting a curtain of compressed dry air thereon. The force of the compressed dry air spreads and thins the binder deposit, leaving behind a uniform film on the wafer. The air knife 50 is mounted on the same gantry frame 46 as the nozzles 44 and though the scanning motions of the two systems are mechanically coupled they are controlled independently of one another and may operate simultaneously or at different times. The air knife 50 also sweeps excess binder "B" off of the wafer. The excess binder makes its way across the clamp ring 42 through channels 52 in the top of the ring 42 and down into a collection basin 54 shown in figure 4. The binder drains towards on one side where it is channeled toward a drain port which drain port is connected to a collector where the excess binder is stored for eventual reuse. After application of the binder, the vacuum support chuck 56 drops, and the vacuum on the cruck and support pins turns off and the robot 22 removes the wafer "W" from the binder module 16. The height, spacing and angles of the binder dispensing nozzles can be manually adjusted. Different lengths and spacings may be used to optimize the distribution pattern of the binder. The height and angle of the air knife 50 can also be manually adjusted. The volume of the binder dispensed is controlled by the dispensed time, reservoir tank pressure and manual knobs on the nozzles themselves. The compressed dry air flow rate through the air knife 50 is controlled by the combination of mass flow controllers and orifices in the facility panel 60, represented in figure 2. Bringing the air knife 50 closer to the surface of the wafer "W" concentrates the force of the air curtain, generally resulting in a thinner binder film. The air knife 50 is also used to clean wafers which may have missing or misaligned solder balls which will require repair in the repair station 198, shown in figure 9D. The air knife 50 blows off all solder balls SB in excess binder from the wafer "W". The binder enclosure 36 is exhausted so that any binder material which remains airborne does not escape and contaminates of the part of the tool assembly.

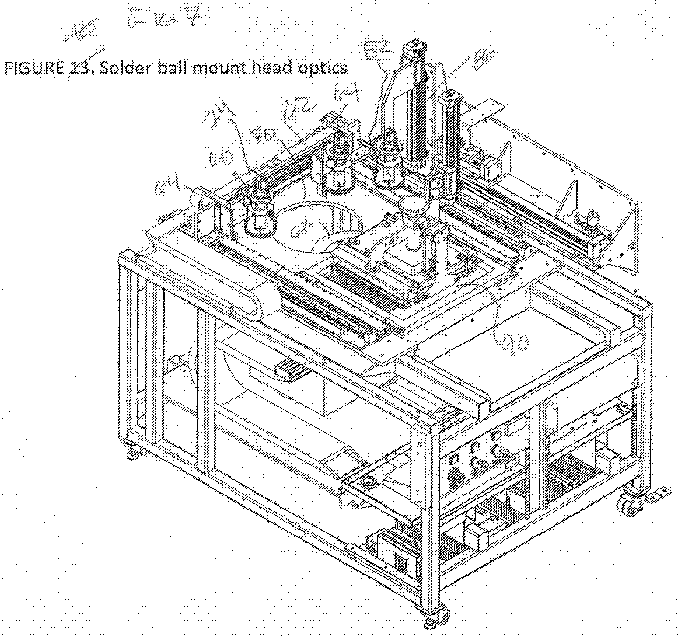

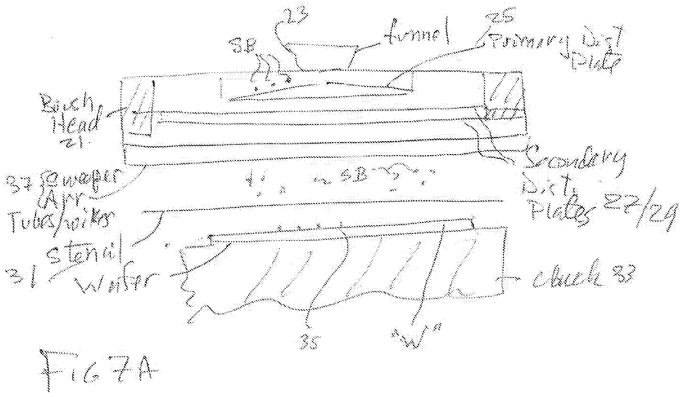

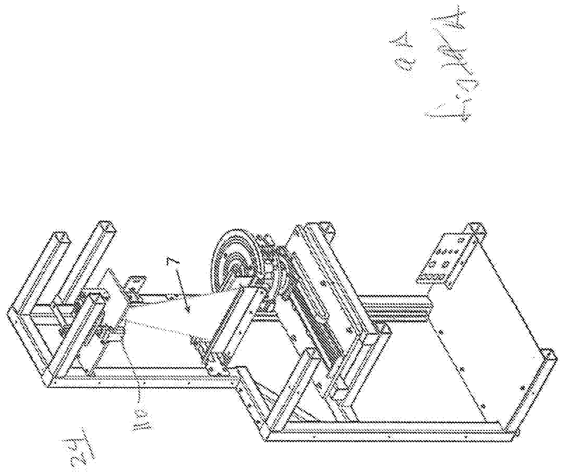

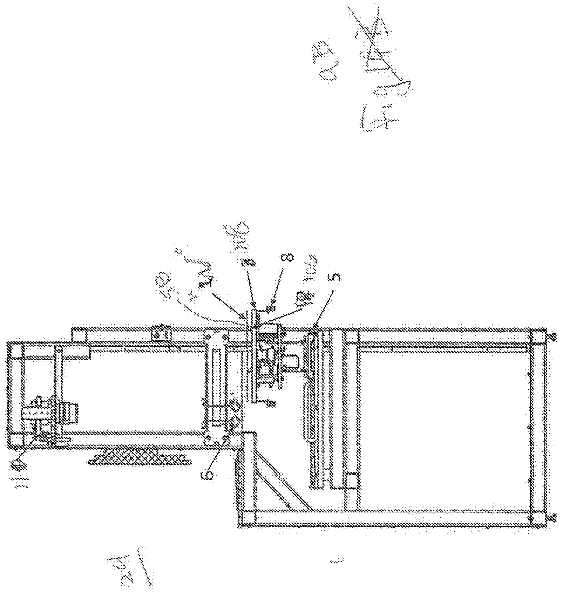

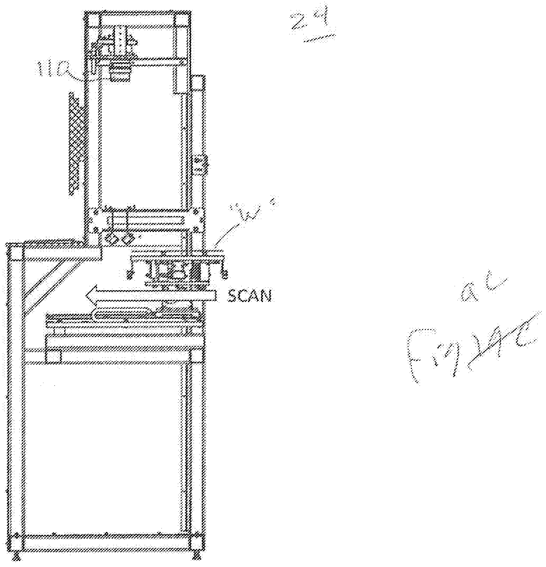

The operation of the chip assembly tool 10 continues with the removal of the solder ball laden wafer "W" by the robotic arm 22 which is represented in figures 2 and 6, and is roughly aligned in the pre-aligner in the load port 12. It is then transferred to the solder ball mount module 18 for optical alignment of the solder balls SB on the wafer W, as represented in figure 9, figure 10 and figure 11. The wafer vacuum support chuck starts in the load position as it accepts the wafer from the robotic arm 22. The wafer plate has support pins with vacuum cups and several sets of independently controlled the vacuum channels or zones in the surface of the support plate. The wafer "W" is first loaded onto the support pins and secured with the vacuum cups. The pins recess into the vacuum support chuck. This lowers the wafer to the chuck surface where it is held by the vacuum zones. The stages actuated in the X, Y, and Z directions by linear actuators with push precision ball screws as represented in figure 6. A high precision turntable also rotates the wafer "W" in the beta stage. All wafer support motions are computer-controlled through a proper circuit. The wafer stage then moves the wafer into the alignment window cutout 70 in the upper mounting plate 66, as shown in figure 6. Two downward looking cameras 60 and 62, shown in figures 6 and 7 are stationed above the wafer "W" such that each camera is looking at a different predetermined location on the wafer. Each camera 60 and 62 is mounted to an independently operated linear drive 64, with a transverse orientation with respect to the mounting plate 66. Both actuators are, in turn, mounted on the gantry frame 74 shown in figure 6 and 7, which gantry 74 can be actuated along the longitudinal axis of the mounting plate using one or two precision ballscrew actuators, wherein each camera 60 and 62 takes an image of a small portion of the wafer "W" and the proper computer, not shown, uses this information to determine the exact location of the wafer in the X, Y and theta configuration. The stage moves the wafer down, over and up through the second stencil window 78 in the mounting plate as shown in figure 6. The stage Z motion raises the wafer "W" so that its upper surface just touches or fits slightly below the bottom surface of the stencil 80. The computer-controlled system already knows the exact orientation of the stencil 80 and in combination with its knowledge of the wafer orientation, can position the wafer so that it is aligned to the stencil 80 with a high degree of accuracy before breaking it up in the Z direction. Verification camera 32 is shown in figure 7 is arranged to confirm the final arrangement of the wafer "W" relative to the stencil 80. By using a pneumatic actuator 86, represented in figure 7, the verification camera 82 moves down to bring the stencil 80 and wafer "W" into focus. The verification camera 82 moves up to get a clear picture of the subsequent operation of the ball mount head 90.

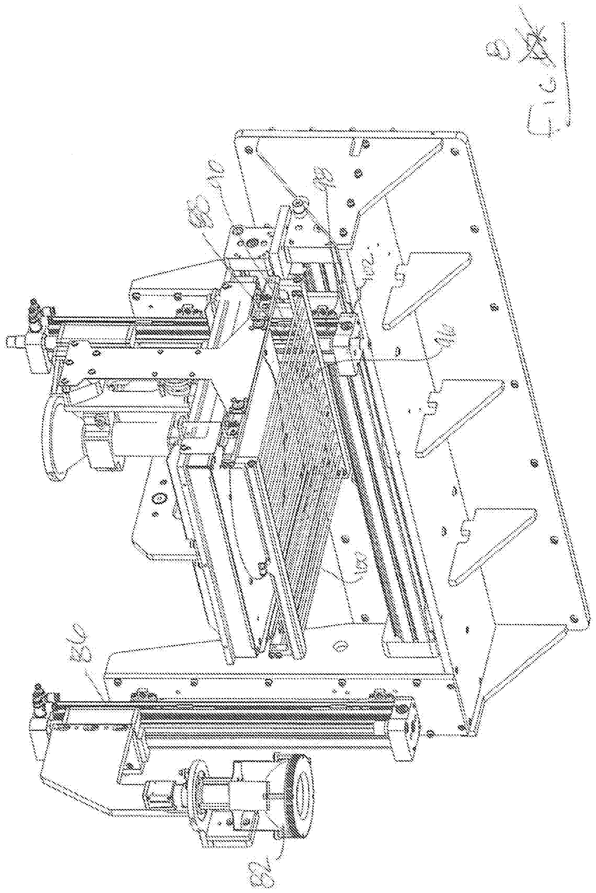

The operation of the chip assembly tool continues as the solder ball mounting head, moves into position over the stencil 80 and is lowered into the dispensing position and very lightly contacts the stencil 80. A rotary nomadic member 88, shown in figure 8, tilts the reservoir 102 and releases a predetermined volume of solder balls SB onto a primary distribution plate. The solder balls SB then move down through holes in several levels of secondary distribution plates and spread out further before finally being dispersed over the surface of the stencil 80. A brush head 96 represented in figure 8 is driven by an pneumatic actuator 98. The brush head 96 contains a series of sweeping members 100, such as wires, or pressurized perforated tubes with the perforations along its lower side, or the like, the sweeping members 100 being shown in figure 8, which are amounted to the underside of the brush head 96 and such they protrude downwardly and make slight contact. When the sweeping members 100 are wires, they are placed under slight tension so that a portion of each wire shown is drawn straight, parallel to the surface of the stencil 80. Straight portions of each sweeping member wire 100 span a distance greater than the diameter of the wafer "W" being processed. Keeping the wire 100 parallel with the stencil surface ensures uniform spacing between the wire 100 and the stencil 80. The gap, if any, between the wire in the stencil can be controlled such that the solder balls SB are retained between each pair of wires that do not pass underneath freely. Once the brush head 96 has been lowered, a computer-controlled electromagnetic vibrator 102, shown in figure 8, drives the brush head 96 with a small oscillatory motion parallel to the plane of the stencil 80 and perpendicular to the axis of the wires or tubes 100, the small amplitude of the vibratory motion is designed to move the solder balls SB over small distances between the wires or pressured air tubes 100 without scratching the stencil 80. While vibrating, the brush head 96 also translates back and forth parallel to the stencil 80 and perpendicularly to the wires or tubes 100 with a limited gross motion, to ensure at any point of the stencil 80 will be swept by a vibrating wire or pressurized tubes 100. Translating the sweeping member wires or pressurized tubes 100 also ensures no holes in the stencil 80 are covered the entire duration of the spreading operation which might prevent solder balls from filling those blocked holes. After spreading the solder balls SB, the holes in the stencil 80 should each contain one solder ball SB to be left upon a pad on the wafer once the wafer and the stencil are separated from one another. There may be extra solder balls SB on the stencil 80 which have not filled holes and these extra or excess solder balls need to be cleared before the wafer is lowered. The brush head 96 moves up and down out of the way and an air knife 50, shown in figure 4, sweeps over the stencil 80 and pushes all extra solder balls SB to the backside of the stencil 80. Flow of air from the air knife 50 is strong enough to sweep away all solder balls not confined within a hole but not so strong as to dislodge the deposited solder balls. The air knife 50 pushes the balls under a flap, which flap acts as a one-way gate to prevent solder balls from rolling back onto the stencil 80. The solder balls collect on the back edge of the stencil 80 where they are sucked up by an overhead vacuum duct. From there the solder balls are conveyed to a collection vessel were all solder balls are separated from the airstream and stored for later reuse.

A schematic representation of a brush head 21 and the solder ball mount module 18, is represented in figure 7A showing a funnel 23 which drops solder balls SB onto a perforated primary distribution plate 25 through which solder balls drop onto secondary distribution plates 27 and 29. Beneath the secondary distribution plates 27 and 29 there is shown the perforated stencil 31. Stencil 31 is shown above a wafer "W" arranged on the support chuck 33, the wafer W having arrangement of pads 35 thereon. A sweeper arrangement 37 is schematically represented attached to the brush shared 21.

Different processes may use solder balls of different sizes and compositions, so avoiding cross-contamination is critical. Each type of solder ball has a dedicated reservoir, brush and collection vessel. These components may be mechanically and/or electronically keyed so that components for use with different solder balls cannot be mixed.

An inspection module 24, first shown in figure 2 is utilized to inspect the wafer "W" after ball placement thereon, to make sure that all solder balls are correctly positioned before being reflowed. The robot 22 loads a wafer "W", as shown in figure 9A with mounted solder balls SB thereon onto a support pin arrangement 106, with vacuum cups thereon, as shown in figure 9 B. Once the pin arrangement 106 supports the wafer "W", they move down, driven by a pneumatic actuator and recess into the vacuum support plate 108 as shown in figure 9B. The support plate 108 contains several independently controlled sets of vacuum channels or zones, which grip the wafer once the support pins drop therefrom. A linescan camera 110, shown in figure 9A is located in the upper portion of the inspection module 24 and looks downwardly, as represented in figure 9A. The support chuck and wafer are translated across the field of view of the linescan camera 110 so as to capture an image of the entire wafer "W". The support chuck is actuated by a computer-controlled precision ballscrew and may be illuminated by an arrangement of artificial light sources. The wafer images are automatically analyzed to identify defects such as missing solder balls, extra solder balls, or solder balls which are misaligned with respect to the wafers, those wafers which pass inspection move on to reflow module while those which fail inspection are stored in a repair or buffer station for later rework.

Such repair station 198 is shown in figure 9D which comprises a base frame 210 supporting a control panel 212, a plurality of controls 214, a granite inspection slab 216 mounted on the base frame 210, a pick and place arm 220 mounted for movement in an X direction, a scanner drive assembly chuck 222 arranged for Y direction movement on the granite inspection slab 216, and an inspection camera assembly 200. An inspection light assembly 202, is shown in its up position, over the scanner drive assembly chuck 222. The inspection light assembly 202 when in the down position provides light for the inspection camera assembly 200 to view a wafer W on the scanner drive assembly chuck 222. The scanner drive assembly 222 moves the wafer under the camera assembly 200 allowing an image of the entire wafer to be generated. Locations of any missing solder balls and of any extra or misplaced solder balls are identified from this image and its coordinates noted within the control computer system associated with the facilities panel 212. The inspection lights 202 may be moved into the up position allowing the pick and place arm 222 move over the wafer W on the scanner drive assembly chuck 222. The pick and place assembly as a needle hub arrangement 230 which includes a vacuum arrangement. As the pick and place assembly 220 hovers over the wafer it removes any misplaced solder balls and disposes of them.

The inspection lights 202 are moved into an up position allowing the pick and place assembly 220 to move in and over the wafer W. By hovering over the wafer, the pick and place assembly 220 may be utilized to replace the solder balls. First, it removes any misplaced solder balls and disposes of them. Next the pick and place assembly 220 adds solder balls to the wafer applications which have been determined to be missing. The pick and place assembly 220 can reach any place on the wafer by utilizing both linear X and Y Drive movement. In between either of these functions it is possible to use the 200 pick and place camera, mounted between actuators to directly view and confirm the placement or removal of a single solder ball. This is important during testing. When the wafer is repaired the pick and place assembly 220 will move out of the way, to the left as shown in figure 9D. Finally, the inspection light assembly 202 will move down allowing the inspection camera 200 and the scanner drive 222 to create a second image of the wafer. If no errors are found the wafer is removed from the inspection plus station transferred to the reflow module, and another wafer may be moved in for repair.

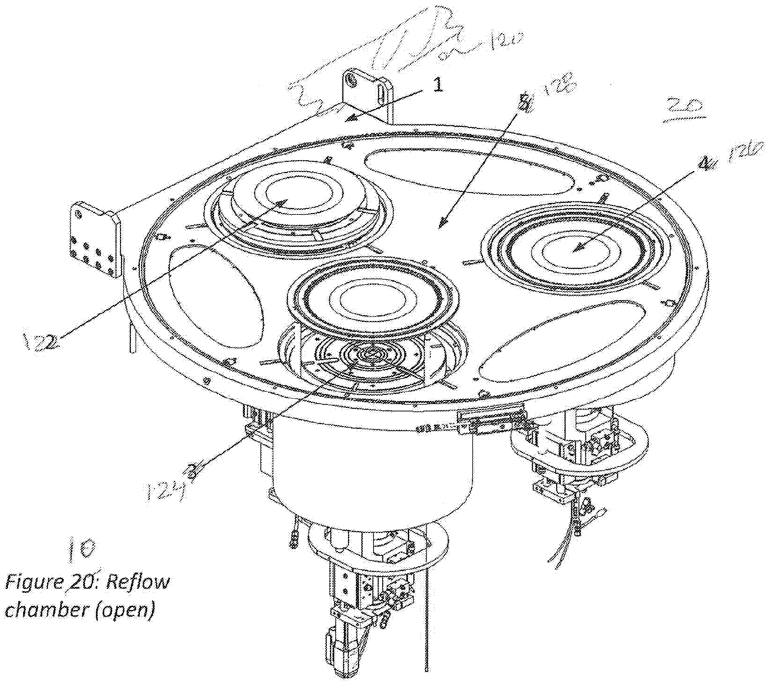

The reflow module 20 shown and discussed extensively in co-pending application number 15/998,295, with its own reference numbers, is incorporated herein by reference, and presently shown consists of an open chamber 120, as shown in figure 10, with three stations: the load lock or first station 122, a reflow or second station 124, and a warpage management station 126. The figures of figure 10 shows a reflow module open. During processing, the chamber is closed and sealed to the ambient environment. Wafers are moved from station to station within the chamber by a rotating carrier disc 128. The disc 128 has multiple slots for serial wafer processing. Each slot holds a carrier ring as shown in figure 5 and a support ring also shown in figure 5 wherein the wafer sits within the support ring. To process wafers, a clamp ring shown in figure 5 may also be used wherein the clamp ring holds the wafer flat during processing and the reflow chamber 20. The outer edge of the wafer is sandwiched between the clamp ring in the support ring forming a temporary annular hold down while the wafers in the reflow chamber.

The load lock or first station 122 of the reflow module 20 accepts a new wafer wherein a load lock vacuum support chuck and baseplate, are raised together by actuating a primary pneumatic cylinder. Mechanism detaches the clamp ring from the support ring to an upper position. A secondary pneumatic ring, is an actuated to lower the support plate with respect to the base plate, thus exposing the support. The load lock door is opened by pneumatic actuators which translate and raise the door. The wafer is loaded by the robot and gripped by vacuum cups on the tips of the support pins. The vacuum support chuck is raised and engages the wafer. The vacuum zones on the chuck, previously described, turn on and hold the wafer flat. A lowering mechanism lowers the clamp ring and locks it into the support ring. The mechanism may also provide additional downward force with the clamp ring to assist in flattening the wafer. This may be needed in cases where vacuum is not sufficient to flatten the wafer. With the baseplate up in the load lock door closed a sealed mini chamber is created. After the wafer is loaded, this chamber is purged with nitrogen to create an oxygen free atmosphere. The support chuck is a baseplate and no oxygen is introduced into the rest of the chamber. This motion also lowers the wafer back into the carrier disc.

The reflow station or second station 124 of the reflow module 20 contains three computer-controlled heating elements: a bottom heater, a top heater and a ring heater are shown in figure 10. The primary purpose of the bottom heaters to conductively heat a wafer "W" by making direct contact with the wafer assembly. The wafer assembly here consists of the wafer, the support ring and the clamp ring. The top heater is used for more gradual convective heating of the wafer within the tower - the tower being the portion of the reflow station above the desk. The ring heater is used to prevent thermal edge losses and improve the temperature uniformity of the wafer. A temperature gradient exists between the top and bottom heaters. The wafer may be positioned at different heights within the tower determines its rate of convective heating i.e. temperature, can be controlled. A hot wall conducts heat from the top heater in the ring heater and creates a more stable and gradual temperature gradient in the tower. The hot wall part may be the same piece which supports and transfers heat from the top heater.

After the wafer is indexed from the load lock into the reflow station, it must be preheated. Preheating is most effectively accomplished by convectively heating the wafer in the tower, in proximity to the top heater. Though the top heater can be set to any temperature, it will normally be set significantly higher than the bottom heater. Therefore, the higher the wafers positioned in the reflow station, the hotter its surroundings become, and the faster it heats up. Elevator pins, driven by a servo motor, lift the wafer assembly and controls its height. The temperature sensors in the support ring contact the wafer and precisely monitor its temperature in real time. The combination of wafer temperature monitoring and wafer height control afford the user great control over the temperature profile of the wafer. At its highest position support ring contacts a hard stop, mounted to the top heater. The stop prevents the wafer assembly from directly contacting the upper portion of the tower, preventing damage to both the tool and the wafer. The stop also conducts heat from the top heater to the support ring, which heats the ring will quickly down the convection heater. Due to the much larger thermal mass, the temperature of the support ring and clamps will lag behind those of the wafer itself decreasing the temperature uniformity of the wafer. Convectively heating the support ring minimizes the difference in heating rates between the wafer and the support ring, thus improving the wafers temperature uniformity. After preheating, the lift pins lower the wafer assembly back into the desk. The bottom heaters then raised, driven by a pneumatic member, and contacts the bottom of the wafer and the support ring contacting the wafer directly, quickly increases the wafer to a uniform study temperature. At this temperature solder balls in the wafer melt and attach to their respective pads on the wafer held by vacuum channels in the bottom heater which can apply a vacuum force to the wafer if desired. Vacuum helps hold a warped wafer flat and improves conductive heating of the wafer both in terms of speed and uniformity. After contacting the wafer for certain period, the bottom heater drops in the wafer indexes the next station.

As the temperature of the wafer increases, even before reflow, metal diffusion between the solder balls and the pads because the solder balls to stick to their pads on the wafer, rendering the binder unnecessary. The liquid binder begins to evaporate at elevated temperature, and by the time the wafer leaves the reflow station all of the binder has been evaporated. An oxygen free reducing atmosphere is maintained in the reflow station, along with the rest of the chamber, to promote oxide removal and solder reflow. The atmosphere is a mixture of nitrogen gas and reducing gas, such as formic acid. After reflow station itself, the reducing gas mixture is introduced through holes in the side of the hot wall, including binder vapor are exhausted through holes in the upper portion of the tower, and eventually make their way to the reflow station exhaust port. Between the reflow station exhaust in the main tool exhaust, a binder condenser system may be placed in line. This condensing system condenses the binder vapor removes it from the exhaust stream, preventing any binder vapor from reaching the facilities exhaust system.

The warpage management station126, that is, the third station of the reflow module 20, shown in figure 10, wherein the wafer and wafer assembly maintain that warpage management station at a temperature above the temperature of the heater and the vacuum plate. The vacuum plate starts out resting on the heater in both there at the same temperature. The plate and heater are each actuated by their own pneumatic cylinders. Plate and heater first move together to contact the wafer. This cools the wafer rapidly and uniformly to below the solder solidification temperature. As with the vacuum support chucks, three zones of vacuum in the plate can apply a vacuum force to the wafer and hold it flat. This improves conduction between the plate in the wafer, especially if the wafer tends to warp. The plate then separates and maintains its back grip on the wafer. Nitrogen gas now flows to the channels on the plate, actively cooling it. Cooling rate may be adjusted by changing the nitrogen flow with the mass flow controller. Keeping the wafer in contact with the plate while the cools, instead of convectively cooling the wafer while suspended freely in the chamber, minimizes or even eliminates residual stress on the wafer. This reduces warpage of the wafer when it is later released from the ring clamp. A nitrogen showerhead, above tire wafer can also convectively cool the wafer with impinging jets of nitrogen gas. After the plate/wafer system is cooled sufficiently, the vacuum releases and the plate separates from the wafer. The wafer now cools exclusively through convection until it leaves the station. While the wafer is cooling, plate drops and contacts the heater again. This heats the plate back up to the starting temperature in preparation for the next wafer.

Although the pneumatic members are controlled independently, the resulting motions of the plate and heater are coupled to a limited extent. The wafer pneumatic member governs the absolute position of the heater, with unique up-and-down positions relative to the chamber. The plate pneumatic can effectively be thought of as a plate/heater separator. It does not control the absolute position of the plate, rather it dictates whether the plate is placed above or is in contact with the heater.

## Claims

1. A unitary wafer assembly arrangement (10) for application of solder balls onto a wafer substrate (W) for subsequent use in the electronics industry, the wafer assembly arrangement (10) comprising: an arrangement of wafer treatment modules, the wafer treatment modules including: a pre-aligner module (14), for receipt of wafers to be treated, a binder module (16), a solder ball mount module (18), for application of a plurality of solder balls (SB) onto the wafer (W), an inspection module (24) including a review and analysis, and insertion and extraction arrangement of misapplied solder balls (SB) deposited on the wafer (W), and a reflow module (20) for heating and securing the solder balls (SB) onto an arrangement of pads on the wafer (W), **characterised in that**:
a central wafer handling robot (22) interconnects and services said wafer treatment modules (14, 16, 18, 20,) to provide a unitary system:
said binder module (16) is configured to apply a flux-less fluid binder (B) onto an upper surface of the wafer (W), said flux-less fluid binder (B) configured for completely evaporating from said upper surface of said wafer (W) at an elevated temperature, said binder module (16) further includes one or more nozzles (44) configured for being scanned across the wafer (W) one or more times, and for evenly distributing the fluid binder (B) by spraying it in a fan pattern approximately normal to the scan direction, and
said binder module (16) further includes an air knife (50), configured for scanning and then jetting a curtain of compressed air over said upper surface of said wafer (W) after said flux-less fluid binder (B) has been sprayed,
said curtain of compressed air from said air knife (50) for spreading and thinning said flux-less binder (B) applied across the upper surface of said wafer (W) leaving behind a uniform film of flux-less fluid binder (B) on said upper surface of said wafer (W).

2. The wafer assembly arrangement (10) as recited in claim 1, wherein, in use, the flux-less fluid binder (B) is applied to the wafer (W) at room temperature or an elevated temperature, wherein the arrangement further comprises a computer-controlled gantry (46) movably disposed over a wafer supported thereunder, and the gantry (46) supports a nozzle arrangement comprising the one or more nozzles, and wherein the arrangement further comprises a collector and drain port, so that, in use, excessive flux-less fluid binder (B) is collected and utilized for a further wafer.

3. The wafer assembly arrangement (10) as recited in claim 2, wherein the solder ball mount module (18) comprises foraminous solder ball alignment plates, so that a plurality of solder balls (SB) are disposed as an array, onto a spaced pattern of solder ball engagement locations on the wafer (W) after the solder balls (SB) have been filtered through a vertical array of the foraminous solder ball alignment plates movably disposed above the wafer (W).

4. The wafer assembly arrangement (10) as recited in claim 3, wherein a further air knife (50) i configured to be driven transversely across the array of solder balls (SB) on the upper surface of the wafer (W) so as to displace any extraneous solder balls (SB) from the surface of the wafer (W).

5. The wafer assembly arrangement (10) as recited in claim 4, wherein a one-way channel is provided, so that, in use, any extraneous solder balls (SB) are passed to the one-way channel for collection and subsequent reuse on a further wafer.

6. A wafer assembly arrangement (10) as recited in claim 1, wherein the arrangement further comprises: a load port module (12) for receipt of the wafers to be treated, a support pin vacuum means (30) to hold the wafer (w), the binder module (16) for holding, in use, each wafer (W) by the support pin vacuum means during the binder spray deposition and binder cleanup operation; a pre-aligner module (14); a solder ball mount module (18) with a vacuum cup pin support means (30), a solder ball distribution stencil (80) and a solder ball distribution reservoir (102) over the stencil (80) for controlled release of solder balls (SB) onto the wafer (W) there below, improper solder ball and excess binder retrieval means; a plurality of cameras for optical alignment review; and a three station reflow module (20) for heat treatment of a loaded wafer (W).

7. The wafer assembly arrangement (10) as recited in claim 6, wherein a computer-controlled gantry (46) is movably disposed over a wafer supported thereunder and is supporting a nozzle arrangement comprising the one or more nozzles, such that, in use, the flux-less fluid binder (B) is applied to the wafer (W) by the nozzle arrangement.

8. The wafer assembly arrangement (10) as recited in claim 7, wherein, in use, a plurality of solder balls (SB) are disposed as an array, onto a spaced pattern of solder ball engagement locations on the wafer (W) after the solder balls (SB) have fallen through a vertical array of foraminous solder ball alignment plates vibratively disposed above the wafer (W).

9. The wafer assembly arrangement (10) as recited in claim 8, wherein another air knife (50) is provided on the gantry (46) and is configured to be driven transversely across the array of solder balls (SB) on the upper surface of the wafer (W) so as to displace any extraneous solder balls (SB) from the surface of the wafer (W).

10. The wafer assembly arrangement (10) as recited in claim 9, wherein a one-way channel is provided, so that, in use, any extraneous solder balls (SB) are passed under a one-way valve to the one-way channel for collection and subsequent reuse on a further wafer.

11. A process for using a plurality of solder balls (SB) in a wafer assembly arrangement (10) for application of the plurality of solder balls (SB) onto a wafer (W) for subsequent use in the electronics industry, **characterised in that** the process comprises:
applying a flux-less fluid binder (B) onto an upper surface of the wafer (W), said flux-less fluid binder (B) configured for completely evaporating from said upper surface of said wafer (W) at an elevated temperature, said flux-less fluid binder (B) being applied by one or more nozzles (44) being scanned across the wafer (W) one or more times, for evenly distributing the fluid binder (B) by spraying it in a fan pattern approximately normal to the scan direction, and
utilizing an air knife (50) by scanning and then jetting a curtain of compressed air across said upper surface of said wafer (W) after said flux-less fluid binder (B) has been sprayed and evenly distributed over the upper surface of said wafer (W), said curtain of compressed air from said air knife (50) for spreading and thinning flux-less fluid binder (B) applied across the upper surface of said wafer (W) leaving behind a uniform film of flux-less fluid binder (B) on said upper surface of said wafer (W);
placing a cartridge of preloaded solder balls (SB) into a receiving unit on the wafer assembly arrangement (10); releasing a limited number of solder balls (10) into a dispensing track in the wafer assembly arrangement (10); dropping the solder balls (SB) through a funnel (23) and into a distribution cup; distributing the solder balls (SB) from the distribution cup onto a primary distribution plate (25); passing the solder balls (SB) through the primary distribution plate (25) and onto a plurality of secondary distribution plates (27, 29); dropping the solder balls (SB) from the secondary distribution plates (27, 29) onto a stencil (80), wherein a wafer (W) is disposed immediately beneath the stencil (80);
sweeping the solder balls (SB) into an array of solder ball receiving holes in the stencil (80);
lowering a solder ball loaded wafer (W) onto a robotic arm pickup; and transferring the solder ball loaded wafer (W) on the robotic arm pickup (22) into an inspection module (24).

12. The process for using a plurality of solder balls (SB) in a wafer assembly arrangement as recited in claim 11, wherein the solder balls (SB) are swept across the stencil (80) by a sweeper arrangement (37) to enable the solder balls (SB) to fill the array of solder ball receiving holes in the stencil (80).

13. The process for using a plurality of solder balls (SB) in a wafer assembly arrangement (10) as recited in claim 12, wherein the sweeper arrangement (37) displacing the solder balls (SB) is an airbrush.

14. The process for using a plurality of solder balls (SB) in a wafer assembly arrangement (10) as recited in claim 12, wherein the sweeper arrangement (37) displacing the solder balls (SB) is a wire brush.

15. The process for using a plurality of solder balls (SB) in a wafer assembly arrangement (10) as recited in claim 11 wherein the primary and secondary distribution plates (25, 27, 29) are vibrating during passage of the solder balls (SB) therethrough.

16. A process for the manufacture of a chip assembly in a unitary wafer assembly system, for use in the electronics industry, comprising the steps of:
processing using all process steps as defined in claim 11;
removing the wafer (W) from a front opening unified pod by a robot (22) wherein the wafer (W) is delivered to a pre-aligner for centering;
transferring the wafer (W) to a binder station (16) by the robot (22) wherein said binder fluid (B) is applied to the wafer (W);
taking the wafer (W) by the robot (22) to a solder ball mount station (18) on a chuck to a first wafer service position opening;
aligning the wafer (W) by a camera arrangement for subsequent orientation of the wafer (W) with a stencil hole pattern;
transferring the wafer (W) to a second wafer service position opening where the stencil (80) resides;
moving a wafer support chuck upwardly to lift the wafer very close to the stencil (80), a distance less than a solder ball diameter;
verifying wafer alignment by a camera verification arrangement on an overhead solder ball head as part of a movable gantry (46), by viewing the wafer (W) through the stencil (80) to identify fiducial marks on the wafer (W);
moving a solder ball head, once wafer alignment has been verified, into proper position over the wafer (W);
dispensing solder balls (SB) from a solder ball reservoir on the solder ball head,
bringing the solder ball head close to the stencil (80);
activating the solder ball head to place a brush (96) over the stencil (80);
moving the brush (96) across the wafer (W) fore and aft, without touching the wafer (W) to push solder balls (SB) into holes in the wafer (W);
blowing compressed dry air by an air knife (50) on the gantry (46) across the stencil (80) so as to reclaim any non-loaded solder balls (SB) into a vacuum enabled collection chamber for subsequent reuse;
delivering robotically of the solder ball laden wafer (W) to a chuck in a load lock station/first station (122) in a reflow module (20) and purging of oxygen from the first station;
holding the wafer (W) on the chuck by a vacuum, and rotatably advancing the chuck to a second station (124) for preheating;
raising the wafer (W) up through the chuck on elevators to a ring a top of a chamber of the second station (124) to reach a highest pre-melt reflow temperature;
lowering the wafer (W) by the elevator through the chuck, to return the wafer to rest on the chuck so as to enable the wafer (W) to reach a controlled reflow temperature, wherein the wafer (W) is then rotated to a third station (126) in the reflow module (20),
separating the wafer (W) from the chuck by a vacuum plate, wherein the wafer (W) is cooled by nitrogen below the plate and above the wafer, a wherein a vacuum transmitted through the chuck holds the wafer (W) flat thereon;
rotating the chuck back to the first station (122) for unloading of a finished wafer (W).

## Patentansprüche

1. Einheitliche Wafer-Montageanordnung (10) zum Aufbringen von Lötkugeln auf ein Wafer-Substrat (W) zur anschließenden Verwendung in der Elektronikindustrie, wobei die Wafer-Montageanordnung (10) aufweist: eine Anordnung von Wafer-Behandlungsmodulen, wobei die Wafer-Behandlungsmodule umfassen: ein Vorausrichtungsmodul (14) zur Aufnahme von zu behandelnden Wafern, ein Bindemittelmodul (16), ein Lötkugel-Montagemodul (18) zum Aufbringen einer Vielzahl von Lötkugeln (SB) auf den Wafer (W), ein Inspektionsmodul (24), das eine Anordnung zur Überprüfung und Analyse sowie eine Anordnung zum Einsetzen und Herausnehmen von falsch aufgebrachten Lötkugeln (SB), die auf dem Wafer (W) abgelegt sind, aufweist, und ein Reflow-Modul (20) zum Erwärmen und Befestigen der Lötkugeln (SB) auf einer Anordnung von Kontaktstellen auf dem Wafer (W), **dadurch gekennzeichnet, dass**:
ein zentraler Wafer-Handhabungsroboter (22) die Wafer-Behandlungsmodule (14, 16, 18, 20) miteinander verbindet und bedient, um ein einheitliches System bereitzustellen;
das Bindemittelmodul (16) derart konfiguriert ist, dass es ein flussmittelfreies Fluid-Bindemittel (B) auf eine obere Fläche des Wafers (W) aufträgt, wobei das flussmittelfreie Fluid-Bindemittel (B) derart konfiguriert ist, dass es bei einer erhöhten Temperatur vollständig von der oberen Fläche des Wafers (W) verdampft, das Bindemittelmodul (16) ferner eine oder mehrere Düsen (44) aufweist, die derart konfiguriert sind, dass sie ein oder mehrere Male über den Wafer (W) gescannt werden und das Fluid-Bindemittel (B) gleichmäßig verteilen, indem sie es in einem Fächermuster etwa senkrecht zu der Scanrichtung versprühen, und
das Bindemittelmodul (16) ferner ein Luftmesser (50) aufweist, das derart konfiguriert ist, dass es die obere Fläche des Wafers (W) scannt und dann einen Druckluftvorhang über die obere Fläche des Wafers (W) ausstößt,
nachdem das flussmittelfreie Fluid-Bindemittel (B) versprüht wurde, wobei der Druckluftvorhang von dem Luftmesser (50) dazu dient, das flussmittelfreie Bindemittel (B), das auf die obere Fläche des Wafers (W) aufgetragen wird, zu verteilen und zu dünnen, wodurch ein gleichmäßiger Film aus flussmittelfreiem Fluid-Bindemittel (B) auf der oberen Fläche des Wafers (W) zurückbleibt.

2. Wafer-Montageanordnung (10) nach Anspruch 1, wobei im Gebrauch das flussmittelfreie Fluid-Bindemittel (B) bei Raumtemperatur oder einer erhöhten Temperatur auf den Wafer (W) aufgebracht wird, wobei die Anordnung ferner ein computergesteuertes Portal (46) aufweist, das bewegbar über einem darunter gehaltenen Wafer angeordnet ist, und das Portal (46) eine Düsenanordnung trägt, welche die eine oder mehreren Düsen aufweist, und wobei die Anordnung ferner eine Sammel- und Ablassöffnung aufweist, so dass im Gebrauch überschüssiges flussmittelfreies Fluid-Bindemittel (B) gesammelt und für einen weiteren Wafer verwendet wird.

3. Wafer-Montageanordnung (10) nach Anspruch 2, wobei das Lötkugel-Montagemodul (18) mit Löchern versehene Lötkugel-Ausrichtungsplatten aufweist, so dass eine Vielzahl von Lötkugeln (SB) als Array auf einem beabstandeten Muster von Lötkugeleingriffspositionen auf dem Wafer (W) angeordnet werden, nachdem die Lötkugeln (SB) durch ein vertikales Array der mit Löchern versehenen Lötkugel-Ausrichtungsplatten gefiltert wurden, die bewegbar über dem Wafer (W) angeordnet sind.

4. Wafer-Montageanordnung (10) nach Anspruch 3, wobei ein weiteres Luftmesser (50) derart konfiguriert ist, dass es quer über das Array von Lötkugeln (SB) auf der oberen Fläche des Wafers (W) bewegt wird, um alle überschüssigen Lötkugeln (SB) von der Oberfläche des Wafers (W) zu verdrängen.

5. Wafer-Montageanordnung (10) nach Anspruch 4, wobei ein Einwege-Kanal vorgesehen ist, so dass bei Gebrauch alle überschüssigen Lötkugeln (SB) in den Einwege-Kanal geleitet werden, um gesammelt und anschließend auf einem weiteren Wafer wiederverwendet zu werden.

6. Wafer-Montageanordnung (10) nach Anspruch 1, wobei die Anordnung ferner aufweist: ein Ladeanschlussmodul (12) zur Aufnahme der zu behandelnden Wafer, eine Trägerstift-Unterdruckeinrichtung (30) zum Halten des Wafers (W), das Bindemittelmodul (16) zum Halten jedes Wafers (W) im Gebrauch durch die Stützstift-Unterdruckeinrichtung während des Bindemittel-Sprühauftrags und des Bindemittel-Reinigungsvorgangs; ein Vorausrichtungsmodul (14); ein Lötkugel-Montagemodul (18) mit einer Unterdruck-Saugnapfstift-Trägereinrichtung (30), eine Lötkugel-Verteilungsschablone (80) und ein Lötkugel-Verteilungsreservoir (102) über der Schablone (80) zum gesteuerten Freisetzen von Lötkugeln (SB) auf den Wafer (W) darunter, eine Einrichtung zur Rückgewinnung von ungeeigneten Lötkugeln und überschüssigem Bindemittel; eine Vielzahl von Kameras zur optischen Ausrichtungsüberprüfung; sowie ein Drei-Stationen-Reflow-Modul (20) zur Wärmebehandlung eines geladenen Wafers (W).

7. Wafer-Montageanordnung (10) nach Anspruch 6, wobei ein computergesteuertes Portal (46) bewegbar über einem darunter gehaltenen Wafer angeordnet ist und eine Düsenanordnung trägt, welche die eine oder mehreren Düsen aufweist, so dass im Gebrauch das flussmittelfreie Fluid-Bindemittel (B) durch die Düsenanordnung auf den Wafer (W) aufgebracht wird.

8. Wafer-Montageanordnung (10) nach Anspruch 7, wobei im Gebrauch eine Vielzahl von Lötkugeln (SB) als ein Array auf einem beabstandeten Muster von Lötkugeleingriffspositionen auf dem Wafer (W) angeordnet sind, nachdem die Lötkugeln (SB) durch ein vertikales Array von mit Löchern versehenen Lötkugelausrichtungsplatten gefallen sind, die vibrierend über dem Wafer (W) angeordnet sind.

9. Wafer-Montageanordnung (10) nach Anspruch 8, wobei ein weiteres Luftmesser (50) an dem Portal (46) vorgesehen und derart konfiguriert ist, dass es quer über das Array von Lötkugeln (SB) auf der oberen Fläche des Wafers (W) gefahren wird, um alle überschüssigen Lötkugeln (SB) von der Oberfläche des Wafers (W) zu verdrängen.

10. Wafer-Montageanordnung (10) nach Anspruch 9, wobei ein Einwege-Kanal vorgesehen ist, so dass im Gebrauch alle überschüssigen Lötkugeln (SB) unter einem Einwegventil zu dem Einwegkanal geleitet werden, um gesammelt und anschließend auf einem weiteren Wafer wiederverwendet zu werden.

11. Verfahren zur Verwendung einer Vielzahl von Lötkugeln (SB) in einer Wafer-Montageanordnung (10) zum Aufbringen der Vielzahl von Lötkugeln (SB) auf einen Wafer (W) zur anschließenden Verwendung in der Elektronikindustrie, **dadurch gekennzeichnet, dass** das Verfahren umfasst:
Aufbringen eines flussmittelfreien Fluid-Bindemittels (B) auf eine obere Fläche des Wafers (W), wobei das flussmittelfreie Fluid-Bindemittel (B) derart konfiguriert ist, dass es bei einer erhöhten Temperatur vollständig von der oberen Fläche des Wafers (W) verdampft, wobei das flussmittelfreie Fluid-Bindemittel (B) durch eine oder mehrere Düsen (44) aufgebracht wird, die ein oder mehrere Male über den Wafer (W) gescannt werden, um das Fluid-Bindemittel (B) gleichmäßig zu verteilen, indem es in einem Fächermuster etwa senkrecht zu der Scanrichtung versprüht wird, und
Verwenden eines Luftmessers (50) durch Scannen und anschließendes Ausstoßen eines Druckluftvorhangs über die obere Fläche des Wafers (W), nachdem das flussmittelfreie Fluid-Bindemittel (B) versprüht und gleichmäßig über die obere Fläche des Wafers (W) verteilt wurde, wobei der Druckluftvorhang von dem Luftmesser (50) zum Verteilen und Verdünnen des flussmittelfreien Fluid-Bindemittels (B), das über die obere Fläche des Wafers (W) aufgetragen wurde, einen gleichmäßigen Film aus flussmittelfreiem Fluid-Bindemittel (B) auf der oberen Fläche des Wafers (W) zurücklässt;
Einsetzen einer Patrone mit vorgeladenen Lötkugeln (SB) in eine Aufnahmeeinheit an der Wafer-Montageanordnung (10); Freigeben einer begrenzten Anzahl von Lötkugeln (10) in eine Ausgabespur in der Wafer-Montageanordnung (10); Fallenlassen der Lötkugeln (SB) durch einen Trichter (23) und in einen Verteilungsnapf; Verteilen der Lötkugeln (SB) aus dem Verteilungsnapf auf eine primäre Verteilungsplatte (25); Weiterleiten der Lötkugeln (SB) durch die primäre Verteilungsplatte (25) und auf eine Vielzahl von sekundären Verteilungsplatten (27, 29); Fallenlassen der Lötkugeln (SB) von den sekundären Verteilungsplatten (27, 29) auf eine Schablone (80),
wobei ein Wafer (W) unmittelbar unter der Schablone (80) angeordnet ist;
Fegen der Lötkugeln (SB) in ein Array von Lötkugel-Aufnahmelöchern in der Schablone (80); Absenken eines mit Lötkugeln beladenen Wafers (W) auf einen Roboterarm-Aufnehmer; und Überführen des mit Lötkugeln beladenen Wafers (W) an dem Roboterarm-Aufnehmer (22) in ein Prüfmodul (24).

12. Verfahren zur Verwendung einer Vielzahl von Lötkugeln (SB) in einer Wafer-Montageanordnung nach Anspruch 11, wobei die Lötkugeln (SB) durch eine Fege-Anordnung (37) über die Schablone (80) gefegt werden, damit die Lötkugeln (SB) das Array der Lötkugel-Aufnahmelöcher in der Schablone (80) füllen können.

13. Verfahren zur Verwendung einer Vielzahl von Lötkugeln (SB) in einer Wafer-Montageanordnung (10) nach Anspruch 12, wobei die die Lötkugeln (SB) verdrängende Fege-Anordnung (37) eine Luftbürste ist.

14. Verfahren zur Verwendung einer Vielzahl von Lötkugeln (SB) in einer Wafer-Montageanordnung (10) nach Anspruch 12, wobei die die Lötkugeln (SB) verdrängende Fege-Anordnung (37) eine Drahtbürste ist.

15. Verfahren zur Verwendung einer Vielzahl von Lötkugeln (SB) in einer Wafer-Montageanordnung (10) nach Anspruch 11, wobei die primären und sekundären Verteilerplatten (25, 27, 29) während des Durchgangs der Lötkugeln (SB) durch sie hindurch vibrieren.

16. Verfahren zur Herstellung einer Chip-Baugruppe in einem einheitlichen Wafer-Montagesystem zur Verwendung in der Elektronikindustrie, umfassend die folgenden Schritte:
Verarbeiten unter Verwendung aller Verfahrensschritte gemäß Anspruch 11;
Entnehmen des Wafers (W) aus einer vorderen Öffnung eines Behälters durch einen Roboter (22), wobei der Wafer (W) zum Zentrieren an einen Vorausrichter zugeführt wird;
Überführen des Wafers (W) an eine Bindemittelstation (16) durch den Roboter (22), wobei das Bindemittelfluid (B) auf den Wafer (W) aufgebracht wird;
Verbringen des Wafers (W) durch den Roboter (22) an eine Lötkugel-Montagestation (18) an einer Spannvorrichtung zu einer ersten Wafer-Servicepositionsöffnung;
Ausrichten des Wafers (W) durch eine Kameraanordnung zur anschließenden Ausrichtung des Wafers (W) an einem Schablonenlochmuster;
Übergeben des Wafers (W) an eine zweite Wafer-Servicepositionsöffnung, wo sich die Schablone (80) befindet;
Bewegen einer Wafer-Spannvorrichtung nach oben, um den Wafer sehr nahe an die Schablone (80) zu heben, wobei ein Abstand geringer ist als ein Lötkugeldurchmesser;
Verifizierung der Wafer-Ausrichtung durch eine Kamera-Verifizierungsanordnung an einem Überkopf-Lötkugelkopf als Teil eines bewegbaren Portals (46), indem der Wafer (W) durch die Schablone (80) betrachtet wird, um Referenzmarken auf dem Wafer (W) zu identifizieren;
Bewegen eines Lötkugelkopfes, nachdem die Ausrichtung des Wafers verifiziert wurde, in eine korrekte Position über dem Wafer (W);
Austragen von Lötkugeln (SB) aus einem Lötkugelreservoir an dem Lötkugelkopf,
Verbringen des Lötkugelkopfs in die Nähe der Schablone (80);
Aktivieren des Lötkugelkopfes, um eine Bürste (96) über der Schablone (80) zu platzieren;
Bewegen der Bürste (96) über den Wafer (W) vor und zurück, ohne den Wafer (W) zu berühren, um Lötkugeln (SB) in Löcher in dem Wafer (W) zu drücken;
Blasen von trockener Druckluft durch ein Luftmesser (50) an dem Portal (46) über die Schablone (80), um alle nicht eingebrachten Lötkugeln (SB) in eine unterdruck-basierte Sammelkammer zur späteren Wiederverwendung rückzugewinnen;
robotisches Zuführen des mit Lötkugeln beladenen Wafers (W) an eine Spannvorrichtung in einer Ladeschleusenstation/ersten Station (122) in einem Reflow-Modul (20) und Ausspülen von Sauerstoff aus der ersten Station;
Halten des Wafers (W) an der Spannvorrichtung durch einen Unterdruck und drehbares Vorschieben der Spannvorrichtung an eine zweite Station (124) zum Vorheizen;
Anheben des Wafers (W) durch die Spannvorrichtung an Hebeeinrichtungen zu einem Ring oberhalb einer Kammer der zweiten Station (124), um eine höchste Vorschmelz-Reflow-Temperatur zu erreichen;
Absenken des Wafers (W) durch die Hebeeinrichtung durch die Spannvorrichtung, um den Wafer wieder an der Spannvorrichtung ruhen zu lassen, so dass der Wafer (W) eine kontrollierte Reflow-Temperatur erreichen kann, wobei der Wafer (W) dann zu einer dritten Station (126) in dem Reflow-Modul (20) gedreht wird,
Trennen des Wafers (W) von der Spannvorrichtung durch eine Unterdruckplatte, wobei der Wafer (W) durch Stickstoff unterhalb der Platte und oberhalb des Wafers gekühlt wird, und wobei ein durch die Spannvorrichtung übertragener Unterdruck den Wafer (W) flach an diesem hält;
Drehen der Spannvorrichtung zurück zu der ersten Station (122) zum Entladen eines fertigen Wafers (W).

## Revendications

1. - Agencement unitaire d'assemblage de plaquettes (10) pour l'application de billes de soudure sur un substrat de plaquette (W) en vue d'une utilisation ultérieure dans l'industrie électronique, l'agencement d'assemblage de plaquettes (10) comprenant : un agencement de modules de traitement de plaquette, les modules de traitement de plaquette comprenant : un module de pré-alignement (14), pour la réception de plaquettes à traiter, un module de liant (16), un module de montage de billes de soudure (18) pour l'application d'une pluralité de billes de soudure (SB) sur la plaquette (W), un module d'inspection (24) comprenant un examen et une analyse, ainsi qu'un agencement d'insertion et d'extraction de billes de soudure (SB) mal appliquées déposées sur la plaquette (W), et un module de refusion (20) pour chauffer et fixer les billes de soudure (SB) sur un agencement de plots sur la plaquette (W), **caractérisé par le fait que** :
un robot central de manipulation de plaquette (22) relie et entretient lesdits modules de traitement de plaquette (14, 16, 18, 20) pour constituer un système unitaire ;
ledit module de liant (16) est configuré pour appliquer un liant fluide sans flux (B) sur une surface supérieure de la plaquette (W), ledit liant fluide sans flux (B) étant configuré pour s'évaporer complètement de ladite surface supérieure de ladite plaquette (W) à une température élevée, ledit module de liant (16) comprend en outre une ou plusieurs buses (44) configurées pour être balayées sur la plaquette (W) une ou plusieurs fois, et pour distribuer de manière uniforme le liant fluide (B) par pulvérisation de celui-ci suivant un motif en éventail approximativement normal à la direction de balayage, et ledit module de liant (16) comprend en outre une lame d'air (50), configurée pour balayer puis projeter un rideau d'air comprimé sur ladite surface supérieure de ladite plaquette (W) une fois que ledit liant fluide sans flux (B) a été pulvérisé, ledit rideau d'air comprimé provenant de ladite lame d'air (50) pour étaler et amincir ledit liant sans flux (B) appliqué sur la surface supérieure de ladite plaquette (W) laissant derrière lui un film uniforme de liant fluide sans flux (B) sur ladite surface supérieure de ladite plaquette (W).

2. - Agencement d'assemblage de plaquettes (10) selon la revendication 1, dans lequel, en utilisation, le liant fluide sans flux (B) est appliqué à la plaquette (W) à température ambiante ou à une température élevée, l'agencement comprenant en outre un portique commandé par ordinateur (46) disposé de manière mobile au-dessus d'une plaquette supportée par celui-ci, et le portique (46) supportant un agencement de buses comprenant la ou les buses, et l'agencement comprenant en outre un collecteur et un port de drainage, de telle sorte qu'en utilisation un excès de liant fluide sans flux (B) est collecté et utilisé pour une autre plaquette.

3. - Agencement d'assemblage de plaquettes (10) selon la revendication 2, dans lequel le module de montage de billes de soudure (18) comprend des plaques d'alignement de billes de soudure foraminées, de telle sorte qu'une pluralité de billes de soudure (SB) sont disposées suivant un réseau, sur un motif espacé d'emplacements d'engagement de billes de soudure sur la plaquette (W) une fois que les billes de soudure (SB) ont été filtrées à travers un réseau vertical des plaques d'alignement de billes de soudure foraminées disposées de manière mobile au-dessus de la plaquette (W).

4. - Agencement d'assemblage de plaquettes (10) selon la revendication 3, dans lequel une lame d'air supplémentaire (50) est configurée pour être entraînée transversalement en travers du réseau de billes de soudure (SB) sur la surface supérieure de la plaquette (W) de façon à déplacer toute bille de soudure (SB) superflue à partir de la surface de la plaquette (W).

5. - Agencement d'assemblage de plaquettes (10) selon la revendication 4, dans lequel un canal unidirectionnel est prévu de telle sorte qu'en utilisation toute bille de soudure (SB) superflue est acheminée jusqu'au canal unidirectionnel en vue d'une collecte et d'une réutilisation ultérieure sur une autre plaquette.

6. - Agencement d'assemblage de plaquettes (10) selon la revendication 1, l'agencement comprenant en outre : un module de port de chargement (2) pour la réception des plaquettes à traiter, un moyen d'aspiration à tiges de support (30) pour maintenir la plaquette (W), le module de liant (16) pour maintenir, en utilisation, chaque plaquette (W) par le moyen d'aspiration à tiges de support pendant l'opération de dépôt de liant par pulvérisation et de nettoyage de liant ; un module de pré-alignement (14) ; un module de montage de billes de soudure (18) avec un moyen de support de tiges à ventouse (30), un pochoir de distribution de billes de soudure (80) et un réservoir de distribution de billes de soudure (102) au-dessus du pochoir (80) pour la libération contrôlée de billes de soudure (SB) sur la plaquette (W) située en dessous ; un moyen de récupération de billes de soudure inappropriées et d'excès de liant ; une pluralité de caméras pour un examen d'alignement optique ; et un module de refusion à trois postes (20) pour le traitement thermique d'une plaquette chargée (W).

7. - Agencement d'assemblage de plaquettes (10) selon la revendication 6, dans lequel un portique commandé par ordinateur (46) est disposé de manière mobile au-dessus d'une plaquette supportée par celui-ci et supporte un agencement de buses comprenant la ou les buses de telle sorte qu'en utilisation le liant fluide sans flux (B) est appliqué sur la plaquette (W) par l'agencement de buses.

8. - Agencement d'assemblage de plaquettes (10) selon la revendication 7, dans lequel, en utilisation, une pluralité de billes de soudure (SB) sont disposées en un réseau, sur un motif espacé d'emplacements d'engagement de billes de soudure sur la plaquette (W) une fois que les billes de soudure (SB) sont tombées à travers un réseau vertical de plaques d'alignement de billes de soudure foraminées disposées vibratoirement au-dessus de la plaquette (W).

9. - Agencement d'assemblage de plaquettes (10) selon la revendication 8, dans lequel une autre lame d'air (50) est prévue sur le portique (46) et est configurée pour être entraînée transversalement en travers du réseau de billes de soudure (SB) sur la surface supérieure de la plaquette (W) de façon à déplacer toute bille de soudure (SB) superflue à partir de la surface de la plaquette (W).

10. - Agencement d'assemblage de plaquettes (10) selon la revendication 9, dans lequel un canal unidirectionnel est prévu de telle sorte qu'en utilisation toute bille de soudure (SB) superflue est acheminée sous une vanne unidirectionnelle jusqu'au canal unidirectionnel en vue d'une collecte et d'une réutilisation ultérieure sur une autre plaquette.

11. - Procédé d'utilisation d'une pluralité de billes de soudure (SB) dans un agencement d'assemblage de plaquettes (10) pour l'application de la pluralité de billes de soudure (SB) sur une plaquette (W) en vue d'une utilisation ultérieure dans l'industrie électronique, **caractérisé par le fait que** le procédé comprend :
appliquer un liant fluide sans flux (B) sur une surface supérieure de la plaquette (W), ledit liant fluide sans flux (B) étant configuré pour s'évaporer complètement de ladite surface supérieure de ladite plaquette (W) à une température élevée, ledit liant fluide sans flux (B) étant appliqué par une ou plusieurs buses (44) balayant la plaquette (W) une ou plusieurs fois, pour distribuer de manière uniforme le liant fluide (B) par pulvérisation de celui-ci suivant un motif en éventail approximativement normal à la direction de balayage, et utiliser une lame d'air (50) par balayage puis projection d'un rideau d'air comprimé en travers de ladite surface supérieure de ladite plaquette (W) une fois que ledit liant fluide sans flux (B) a été pulvérisé et réparti de manière uniforme sur la surface supérieure de ladite plaquette (W), ledit rideau d'air comprimé provenant de ladite lame d'air (50) pour étaler et amincir le liant fluide sans flux (B) appliqué sur la surface supérieure de ladite plaquette (W) laissant derrière lui un film uniforme de liant fluide sans flux (B) sur ladite surface supérieure de ladite plaquette (W) ;
placer une cartouche de billes de soudure préchargées (SB) dans une unité de réception sur l'agencement d'assemblage de plaquettes (10) ; libérer un nombre limité de billes de soudure (10) dans une voie de distribution dans l'agencement d'assemblage de plaquettes (10) ; faire tomber les billes de soudure (SB) à travers un entonnoir (23) et dans une coupelle de distribution ; distribuer les billes de soudure (SB) à partir de la coupelle de distribution sur une plaque de distribution primaire (25) ; faire passer les billes de soudure (SB) à travers la plaque de distribution primaire (25) et sur une pluralité de plaques de distribution secondaires (27,29) ; faire tomber les billes de soudure (SB) à partir des plaques de distribution secondaires (27, 29) sur un pochoir (80), une plaquette (W) étant disposée immédiatement sous le pochoir (80) ; balayer les billes de soudure (SB) dans un réseau de trous de réception de billes de soudure dans le pochoir (80) ; abaisser une plaquette chargée de billes de soudure (W) sur un bras robotique ; et transférer la plaquette chargée de billes de soudure (W) sur le bras robotique (22) dans un module d'inspection (24).

12. - Procédé d'utilisation d'une pluralité de billes de soudure (SB) dans un agencement d'assemblage de plaquettes (10) selon la revendication 11, dans lequel les billes de soudure (SB) sont balayées en travers du pochoir (80) par un agencement de balayage (37) pour permettre aux billes de soudure (SB) de remplir le réseau de trous de réception de billes de soudure dans le pochoir (80).

13. - Procédé d'utilisation d'une pluralité de billes de soudure (SB) dans un agencement d'assemblage de plaquettes (10) selon la revendication 12, dans lequel l'agencement de balayage (37) déplaçant les billes de soudure (SB) est un aérographe.

14. - Procédé d'utilisation d'une pluralité de billes de soudure (SB) dans un agencement d'assemblage de plaquettes (10) selon la revendication 12, dans lequel l'agencement de balayage (37) déplaçant les billes de soudure (SB) est une brosse métallique.

15. - Procédé d'utilisation d'une pluralité de billes de soudure (SB) dans un agencement d'assemblage de plaquettes (10) selon la revendication 11, dans lequel les plaques de distribution primaire et secondaires (25, 27, 29) vibrent lors du passage des billes de soudure (SB) à travers celles-ci.

16. - Procédé de fabrication d'un assemblage de puces dans un système unitaire d'assemblage de plaquettes, destiné à être utilisé dans l'industrie électronique, comprenant les étapes :
traiter en utilisant toutes les étapes du procédé tel que défini dans la revendication 11 ;
retirer la plaquette (W) d'un boîtier universel à ouverture frontale par un robot (22), la plaquette (W) étant délivrée à un pré-aligneur en vue d'un centrage ;
transférer la plaquette (W) à un poste de liant (16) par le robot (22), le fluide de liant (B) étant appliqué sur la plaquette (W) ;
amener la plaquette (W) par le robot (22) jusqu'à un poste de montage de billes de soudure (18) sur un mandrin à une première ouverture de position d'entretien de plaquette ;
aligner la plaquette (W) par un agencement de caméras pour une orientation ultérieure de la plaquette (W) avec un motif de trous de pochoir ;
transférer la plaquette (W) à une seconde ouverture de position d'entretien de plaquette où se trouve le pochoir (80) ;
déplacer un mandrin de support de plaquette vers le haut pour lever la plaquette très près du pochoir (80), à une distance inférieure à un diamètre de bille de soudure ;
vérifier un alignement de plaquette par un agencement de vérification par caméra sur une tête de bille de soudure suspendue faisant partie d'un portique mobile (46), en visualisant la plaquette (W) à travers le pochoir (80) pour identifier des repères sur la plaquette (W) ;
déplacer une tête de bille de soudure, une fois l'alignement de plaquette vérifié, dans une position appropriée sur la plaquette (W) ;
distribuer des billes de soudure (SB) à partir d'un réservoir de billes de soudure sur la tête de bille de soudure ;
approcher la tête de bille de soudure du pochoir (80) ;
activer la tête de bille de soudure pour placer une brosse (96) sur le pochoir (80) ;
déplacer la brosse (96) sur la plaquette (W) d'avant en arrière, sans toucher la plaquette (W), pour pousser des billes de soudure (SB) dans des trous de la plaquette (W) ;
souffler de l'air sec comprimé à l'aide d'une lame d'air (50) sur le portique (46) à travers le pochoir (80) de façon à récupérer toute bille de soudure (SB) non chargée, dans une chambre de collecte sous vide en vue d'une réutilisation ultérieure ;
délivrée de manière robotisée la plaquette chargée de billes de soudure (W) à un mandrin dans un premier poste/poste de verrouillage de charge (122) dans un module de refusion (20), et purger l'oxygène du premier poste ;
maintenir la plaquette (W) sur le mandrin par un vide, et faire avancer le mandrin de manière rotative jusqu'à un deuxième poste (124) en vue d'un préchauffage ;
surélever la plaquette (W) à travers le mandrin sur des élévateurs jusqu'à un anneau, au sommet d'une chambre du deuxième poste (124), pour atteindre la température de refusion pré-fondue la plus élevée ;
abaisser la plaquette (W) par l'élévateur à travers le mandrin, pour ramener la plaquette en repos sur le mandrin de façon à permettre à la plaquette (W) d'atteindre une température de refusion contrôlée, la plaquette (W) étant ensuite tournée jusqu'à un troisième poste (126) dans le module de refusion (20) ;
séparer la plaquette (W) du mandrin par une plaque à vide, la plaquette (W) étant refroidie par de l'azote sous la plaque et au-dessus de la plaquette, un vide transmis à travers le mandrin maintenant la plaquette (W) à plat sur celui-ci ;
faire tourner le mandrin jusqu' au premier poste (122) pour le déchargement d'une plaquette finie (W).
